# EUROPEAN PATENT APPLICATION

(11) **EP 4 848 928 A1**
(43) Date of publication of application: **02.12.2026**
(21) Application number: 26173092.3
(22) Date of filing: 17.04.2026
(51) Int. Cl.: H10B 61/00, H10N 50/01, H10N 50/10

(54) **SEMICONDUCTOR DEVICE AND METHOD FOR FABRICATING THE SAME**

(30) Priority: 26.05.2025 KR 20250068195
(71) Applicant: SK hynix Inc., Bubal-eub Icheon-si, Gyeonggi-do 17336 (KR)
(72) Inventor: DONG, Cha Deok, 17336 Icheon-si, Gyeonggi-do (KR); KIM, Jeong Myeong, 17336 Icheon-si, Gyeonggi-do (KR); CHOI, Keo Rock, 17336 Icheon-si, Gyeonggi-do (KR)
(74) Representative: Isarpatent

(57) **Abstract**

Disclosed are a semiconductor device and a method for fabricating the same. The semiconductor device includes a first conductive line extending in a first direction; a gap-fill oxide layer filling a region disposed adjacent to the first conductive lines; a first electrode layer line formed over the first conductive line and including a carbon-based material; a magnetic tunnel junction (MTJ) pattern formed over the first electrode layer line; a first inter-layer dielectric layer formed in a space adjacent to the MTJ patterns; a selector pattern disposed over the MTJ pattern; a carbon-based thin layer pattern disposed over the selector pattern; a second inter-layer dielectric layer formed in a space adjacent to the selector patterns; and a second conductive line disposed over the carbon-based thin layer pattern and extending in a second direction that intersects with the first direction.

## Description

### BACKGROUND

### 1. Field

Various embodiments of the present disclosure relate generally to semiconductor technology, and more particularly, to a semiconductor device including a Magnetic Tunnel Junction (MTJ) structure, and a method for fabricating the same.

### 2. Description of the Related Art

Recently, semiconductor devices capable of storing data in diverse electronic devices, such as computers and portable communication devices, are demanded to cope with the trends of miniaturization, low power consumption, high performance, and diversification of electronic devices, and researchers and the industry are studying to develop such semiconductor devices. The semiconductor devices include those capable of storing data by taking advantage of the characteristics of switching between different resistance states according to the applied voltage or current, for example, a Resistive Random Access Memory (RRAM), a Phase-change Random Access Memory (PRAM), a Ferroelectric Random Access Memory (FRAM), a Magneto-resistive Random Access Memory (MRAM), an e-fuse and the like.

### SUMMARY

Embodiments of the present disclosure are directed to a semiconductor device and a method for fabricating the same that may prevent damage to a lower portion of a cell during a Magnetic Tunnel Junction (MTJ) etching process, improve the process precision, and improve electrical isolation between the cells by disposing an MTJ pattern in the lower portion of the cell, using a carbon-based thin layer as an electrode layer and an etch stop layer, and using a silicon nitride (NIT) dielectric layer as an etch stop layer during a selector pattern etching process.

In accordance with an embodiment of the present disclosure, a semiconductor device includes a first conductive line extending in a first direction; a gap-fill oxide layer filling a region disposed adjacent to the first conductive line; a first electrode layer line formed over the first conductive line and including a carbon-based material; a magnetic tunnel junction (MTJ) pattern formed over the first electrode layer line; a first inter-layer dielectric layer formed in a space adjacent to the MTJ pattern; a selector pattern disposed over the MTJ pattern; a carbon-based thin layer pattern disposed over the selector pattern; a second inter-layer dielectric layer formed in a space adjacent to the selector pattern; and a second conductive line disposed over the carbon-based thin layer pattern and extending in a second direction that intersects with the first direction.

In accordance with another embodiment of the present disclosure, a method for fabricating a semiconductor device includes forming a first conductive line extending in a first direction; forming a gap-fill oxide layer by filling a region between the first conductive lines with an oxide layer; forming a first electrode layer line including a carbon-based material over the gap-fill oxide layer; forming a magnetic tunnel junction (MTJ) layer over the first electrode layer line; forming an MTJ pattern by patterning the MTJ layer with the first electrode layer line or the gap-fill oxide layer used as an etch stop layer; forming a first inter-layer dielectric layer in a space between the MTJ patterns; forming a selector layer over the MTJ pattern and forming a carbon-based thin layer over the selector layer; forming a selector pattern by patterning the selector layer with the first inter-layer dielectric layer used as an etch stop layer; and forming a second conductive line extending in a second direction that intersects with the first direction over the selector pattern.

These and other features and advantages of the embodiments of the present disclosure will become apparent to those skilled in the art of the invention from the following detailed description in conjunction with the following drawings.

### BRIEF DESCRIPTION OF THE DRAWINGS

FIG. 1 is a perspective view illustrating a semiconductor device in accordance with an embodiment of the present disclosure.
FIG. 2 is a cross-sectional view illustrating a semiconductor device in accordance with an embodiment of the present disclosure.
FIGS. 3A to 3N are cross-sectional views illustrating a semiconductor device and a method for fabricating the same in accordance with an embodiment of the present disclosure.

### DETAILED DESCRIPTION

Hereinafter, various embodiments of the present disclosure will be described in detail with reference to the attached drawings.

Various embodiments of the present disclosure will be described below in more detail with reference to the accompanying drawings. The embodiments may, however, be embodied in different forms and should not be construed as limited to the embodiments set forth herein. Rather, these embodiments are provided so that this disclosure will be thorough and complete, and will fully convey the scope of the present disclosure to those with ordinary skill in the art. Throughout the disclosure, like reference numerals refer to like parts throughout the various figures and embodiments of the present disclosure.

The drawings are not necessarily to scale and in some instances, proportions may have been exaggerated to clearly illustrate the various features of the embodiments. When a first layer is referred to as being "on" a second layer or "on" a substrate, it not only refers to a case where the first layer is formed directly on the second layer or the substrate but also a case where a third layer exists between the first layer and the second layer or the substrate.

The cell structure of a general Storage Class Magneto-resistive Random Access Memory (SC-MRAM) may be formed by disposing a Magnetic Tunnel Junction (MTJ) pattern in the upper portion, which frequently causes such problems as the increased number of processes, decreased patterning precision, damage to the lower portion, and leakage current occurring between cells. In particular, the major factors for lowering the reliability and yield of the device may include damage to a lower electrode layer that occurs during a process of etching the MTJ layer, interference to the lower MTJ pattern during a process for forming a selector pattern, defects that may be caused by a re-deposited material during the process, and the like.

The embodiments of the present disclosure are intended to solve these problems of the general technology and may provide a semiconductor device and a method for fabricating the same that may be able to prevent damage to the MTJ pattern, improve the precision of the etching process and the electrical isolation between cells, and consequently improve the process stability and the device reliability by disposing the MTJ pattern in the lower portion of the cell and using a carbon-based thin layer and a silicon nitride (NIT) dielectric layer as an etch stop layer.

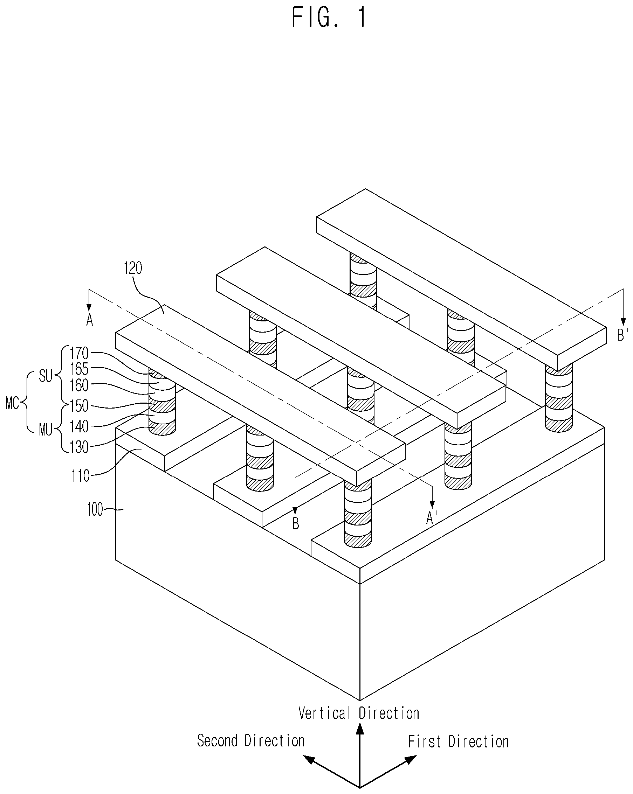

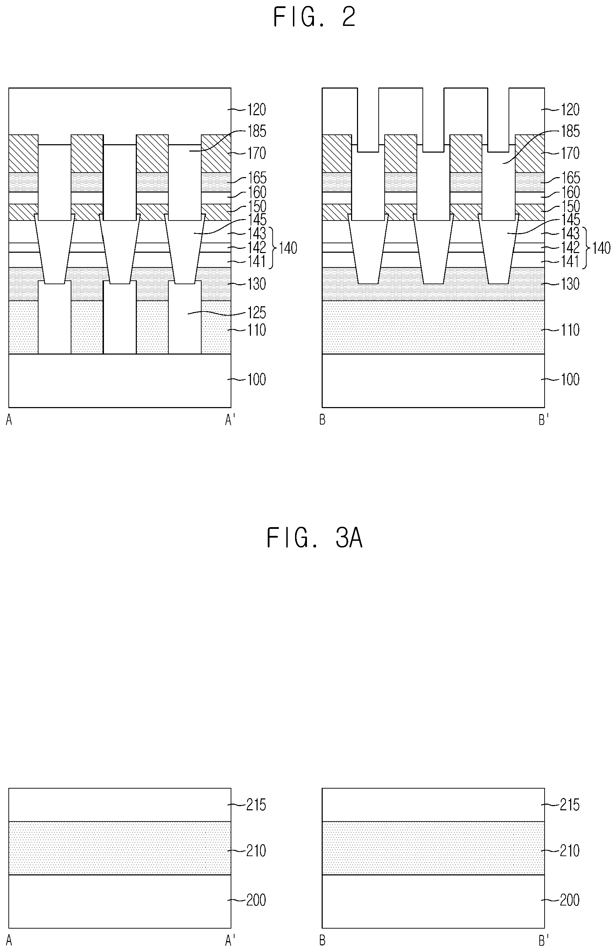

FIGS. 1 and 2 illustrate a semiconductor device in accordance with an embodiment of the present disclosure. FIG. 1 is a perspective view illustrating the semiconductor device in accordance with the embodiment of the present disclosure, and FIG. 2 is a cross-sectional view taken along a line A-A' and a line B-B' shown in FIG. 1.

Referring to FIGS. 1 and 2, the semiconductor device in accordance with an embodiment of the present disclosure may include a substrate 100, a plurality of first conductive lines 110 disposed over the substrate 100 and extending in a first direction and parallel to each other, a plurality of second conductive lines 120 disposed over the first conductive lines 110 and extending in a second direction that intersects with the first direction and parallel to each other, and a plurality of memory cells MC interposed between the first conductive lines 110 and the second conductive lines 120 and respectively overlapping with the intersection areas between the first conductive lines 110 and the second conductive lines 120. Here, the first direction and the second direction refer to directions substantially parallel to the surface of the substrate 100. A direction substantially perpendicular to the surface of the substrate 100 may be, hereinafter, referred to as a vertical direction.

The substrate 100 may be, for example, a silicon substrate, a gallium arsenide substrate, a silicon germanium substrate, a ceramic substrate, a quartz substrate, or a glass substrate for a display, or the substrate 100 may be an SOI (Semiconductor-On-Insulator) substrate but the embodiments of the present disclosure are not limited thereto. Also, the substrate 100 may include a required predetermined lower structure (not shown). For example, the substrate 100 may include an integrated circuit for driving the first conductive lines 110 and/or the second conductive lines 120.

The first conductive line 110 and the second conductive line 120 may be coupled to both ends of the memory cell MC, respectively. Either one of the first conductive lines 110 and the second conductive lines 120 may function as word lines, and bit lines, respectively. Each of the first conductive lines 110 and the second conductive lines 120 may include diverse conductive materials, for example, metals such as platinum (Pt), tungsten (W), aluminum (Al), copper (Cu), tantalum (Ta), titanium (Ti) and the like, metal nitrides such as titanium nitride (TiN), tantalum nitride (TaN), tungsten nitride (WN) and the like, or a combination thereof, and each of the first conductive lines 110 and the second conductive lines 120 may have a single-layer structure or a multi-layer structure.

The memory cells MC may have a shape of pillars that overlap with the intersection area between the first conductive lines 110 and the second conductive lines 120, respectively. For example, each of the memory cells MC may have a square pillar shape in which both sidewalls in the first direction are aligned with both sidewalls of the second conductive line 120, and both sidewalls in the second direction are aligned with both sidewalls of the first conductive line 110. However, the embodiments of the present disclosure are not limited thereto, and as long as the memory cells MC overlap with the intersection areas between the first conductive lines 110 and the second conductive lines 120, the planar shape of the memory cells MC may be diversely modified, such as a circle, an ellipse, a polygon and the like.

Also, although the first electrode layer pattern 130 is illustrated to have a pillar shape in accordance with the embodiment of the present disclosure, it may be formed in a line shape according to the process conditions or the device design. For example, in a structure in which the memory cell array is disposed long in a single direction, a line-shaped electrode pattern may be suitable, and even in this case, the process flow linked to the formation of the MTJ pattern 140 and the subsequent selector pattern 160 may be similarly applied.

Each memory cell MC may include a first electrode layer pattern 130, an MTJ pattern 140, a second electrode layer pattern 150, a selector pattern 160, a carbon-based thin layer pattern 165, and a third electrode layer pattern 170. The first electrode layer pattern 130, the MTJ pattern 140, and the second electrode layer pattern 150 may form a memory unit MU, and the second electrode layer pattern 150, the selector pattern 160, the carbon-based thin layer pattern 165, and the third electrode layer pattern 170 may form a selector unit SU. The memory unit MU and the selector unit SU may share the second electrode layer pattern 150.

The first electrode layer pattern 130 and the third electrode layer pattern 170 may be disposed at the bottom and top of the memory cell MC, respectively, and may each function as a passage for transferring a voltage or current. The second electrode layer pattern 150 may function as a conduit for transferring a voltage or current between the MTJ pattern 140 and the selector pattern 160 by electrically connecting the MTJ pattern 140 and the selector pattern 160 to each other while physically separating them from each other. The first electrode layer pattern 130 may include one or more selected from the group including carbon-based materials, for example, amorphous carbon, graphite carbon, and a doped carbon thin layer. Each of the second electrode layer pattern 150 and the third electrode layer pattern 170 may independently include diverse conductive materials, for example, metals such as platinum (Pt), tungsten (W), aluminum (Al), copper (Cu), tantalum (Ta), titanium (Ti) and the like, metal nitrides such as titanium nitride (TiN), tantalum nitride (TaN), tungsten nitride (WN) and the like, carbon (C), or combinations thereof, and each of the second electrode layer pattern 150 and the third electrode layer pattern 170 may have a single-layer structure or a multi-layer structure.

The MTJ pattern 140 may function to store data in diverse ways. For example, the MTJ pattern 140 may include a variable resistance layer that stores different data by switching between different resistance states according to a voltage or current supplied through the upper and lower portions of the MTJ pattern 140. The variable resistance layer may have a single-layer structure or a multi-layer structure including diverse materials used in a Resistive Random Access Memory (RRAM), a Phase-change Random Access Memory (PRAM), a Ferroelectric Random Access Memory (FRAM), a Magneto-resistive Random Access Memory (MRAM) and the like, for example, metal oxides such as transition metal oxides, perovskite-based materials and the like, phase-change materials such as chalcogenide-based materials and the like, ferroelectric materials, ferromagnetic materials and the like.

The selector pattern 160 may have a function of preventing current leakage between the memory cells MC sharing the first conductive line 110 or the second conductive line 120 while controlling the access to the MTJ pattern 140. To this end, the selector pattern 160 may have the threshold switching characteristics of blocking the current or holding the current to hardly flow when the level of the voltage supplied to the upper and lower ends of the selector pattern 160 is below a predetermined threshold voltage level, and then letting the current flow rapidly when the threshold voltage level is equal to or higher than the threshold voltage level. The selector pattern 160 may be turned on at a voltage level which is equal to or higher than the threshold voltage and may be turned off at a voltage level which is lower than the threshold voltage level. Thus, the selector pattern 160 serves to prevent current leakage between shared memory cells by utilizing threshold switching behavior that enables current flow only when the applied voltage meets or exceeds a specified threshold.

The selector pattern 160 may include an Ovonic Threshold Switching (OTS) material such as a diode, a chalcogenide-based material and the like, a Mixed Ionic Electronic Conducting (MIEC) material such as a metal-containing chalcogenide-based material, a Metal Insulator Transition (MIT) material such as niobium dioxide (NbO₂), vanadium oxide (VO₂) and the like, or a tunneling dielectric material having a relatively wide band gap such as silicon dioxide (SiO₂), aluminum oxide (Al₂O₃) and the like.

Also, the selector pattern 160 may be designed to have a threshold voltage of approximately 0.5 V to 1.5 V. The threshold switching characteristics of the selector pattern 160 may be adjusted according to the composition and doping conditions of the material used. For example, niobium dioxide (NbO₂), vanadium oxide (VO₂) or a combination of materials such as arsenic (As)-doped silicon dioxide (SiO₂), boron (B) or gallium (Ga)-doped silicon nitride (Si₃N₄) and the like may be used.

In an embodiment, the selector pattern 160 may include a dielectric material layer that is doped with a dopant. For example, the dielectric material layer may include a silicon-containing dielectric material such as silicon oxide, silicon nitride, silicon oxynitride and the like, a dielectric metal oxide, a dielectric metal nitride, or a combination thereof. There may be a deep trap whose energy level is closer to the energy level of the valence band than to the energy level of the conduction band of the dielectric material layer in the dielectric material layer. The dopant may serve to create a shallow trap that provides a path through which conductive carriers move, such as electrons or holes, in the dielectric material layer. The shallow trap may have a work function which is smaller than either of the work function of the first electrode layer 120 and the work function of the second electrode layer 140 and may have an energy level which is closer to the energy level of the conduction band than to the energy level of the valence band of the dielectric material layer. For example, when the dielectric material layer contains silicon, the dopant may include a metal having a different valence from that of silicon, such as gallium (Ga), boron (B), indium (In), phosphorus (P), arsenic (As), antimony (Sb), germanium (Ge), carbon (C), tungsten (W), or a combination thereof. Also, when the dielectric material layer contains a metal, the dopant may include a metal having a different valence from that of the metal, silicon and the like. For example, the selector pattern 160 may include silicon oxide doped with arsenic (As), such as silicon dioxide (SiO₂) doped with arsenic. When a voltage which is equal to or higher than the threshold voltage is applied to the selector pattern 160, the carriers trapped in the deep trap may jump to the shallow trap by thermal emission or tunneling, and a conductive path coupling the first electrode layer pattern 130 and the second electrode layer pattern 150 may be created as the carriers move through the shallow trap. An on-state in which current flows through the selector pattern 160 may be realized. On the other hand, when no voltage is applied to the selector pattern 160 or a voltage lower than the threshold voltage is applied, the phenomenon that the carriers jump to the shallow trap may be reduced or prevented, and thus the conductive path may be disconnected. An off-state in which current does not flow through the selector pattern 160 may be realized.

The carbon-based thin layer pattern 165 is formed over the selector pattern 160. The carbon-based thin layer pattern 165 may function as a protective layer or a buffer layer that provides stable electrical contact between the second conductive line 120, which is to be formed subsequently, and the selector pattern 160 and prevents damage to the lower selector pattern 160 and the MTJ pattern 140.

Also, the carbon-based thin layer pattern 165 may function as a barrier layer against metal re-deposition or metal contamination that may occur during the etching process. The carbon-based thin layer pattern 165 may also function as a dielectric isolation layer that reduces the capacitive or conductive interference between neighboring lines when the second conductive lines 120 of the upper portion are formed.

In particular, the carbon-based thin layer may be formed by performing a deposition followed by planarization through an etch-back process, thereby providing a base for precisely forming a metal line in the upper portion, and as a result, it may contribute to increasing the overlay alignment precision of the upper and lower portions and fabrication reliability.

According to an embodiment of the present disclosure, the memory cell MC may include a stacked structure of the first electrode layer pattern 130, the MTJ pattern 140, the second electrode layer pattern 150, the selector pattern 160, the carbon-based thin layer pattern 165, and the third electrode layer pattern 170, but the embodiments of the present disclosure are not limited thereto, and the layer structure of the memory cell MC may be diversely modified. For example, at least one of the second electrode layer pattern 150 and the third electrode layer pattern 170 may be omitted. Also, for example, the memory cell MC may further include one or more layers (not shown) to improve the characteristics or the process.

In the semiconductor device, the material, structure and the like of the second electrode layer pattern 150 or the third electrode layer pattern 170 that contacts and/or is coupled to the selector pattern 160 may be controlled in order to improve the diverse characteristics of the selector pattern 160.

Referring to FIG. 2, the MTJ pattern 140 in accordance with an embodiment of the present disclosure may include a fixed layer pattern 141, a tunnel barrier layer pattern 142, and a free layer pattern 143.

The fixed layer pattern 141 may have a fixed magnetization direction. For example, the magnetization direction of the fixed layer pattern 141 may be fixed regardless of the program current passing through the fixed layer pattern 141.

The fixed layer pattern 141 may include a ferromagnetic substance. For example, the fixed layer pattern 141 may include at least one among an amorphous rare earth element alloy, a multi-layer thin layer in which a ferromagnetic metal FM and a non-magnetic metal NM are alternately stacked, an alloy having an L1₀-type crystal structure, a cobalt-based alloy, and a combination thereof, but the embodiments of the present disclosure are not limited thereto.

The amorphous rare earth element alloy may include, for example, an alloy such as terbium-iron (TbFe), terbium-cobalt (TbCo), terbium-iron-cobalt (TbFeCo), dysprosium-terbium-iron-cobalt (DyTbFeCo), gadolinium-terbium-cobalt (GdTbCo), and the like. The multi-layer thin layer in which the ferromagnetic metal and the nonmagnetic metal are alternately stacked may include, for example, a multi-layer thin layer such as cobalt/platinum (Co/Pt), cobalt/palladium (Co/Pd), cobalt-chromium/platinum (CoCr/Pt), cobalt/ruthenium (Co/Ru), cobalt/osmium (Co/Os), cobalt/gold (Co/Au), nickel/copper (Ni/Cu), and other transition metal heterostructures. The alloy having the L1₀-type crystal structure may include, for example, alloys such as iron-platinum (FesoPtso), iron-palladium (FesoPdso), cobalt-platinum (CosoPtso), iron-nickel-platinum (Fe₃₀Ni₂₀Pt₅₀), cobalt-nickel-platinum (Co₃₀Ni₂₀Pt₅₀) and the like. The cobalt based alloy may include, for example, cobalt-chromium (CoCr), cobalt-platinum (CoPt), cobalt-chromium-platinum (CoCrPt), cobalt-chromium-tantalum (CoCrTa), cobalt-chromium-platinum-tantalum (CoCrPtTa), cobalt-chromium-niobium (CoCrNb), cobalt-iron-boron (CoFeB), and the like. In an embodiment, as described below the fixed layer pattern 141 includes CoFeB.

According to some embodiments of the present disclosure, the fixed layer pattern 141 may have perpendicular magnetic anisotropy (PMA). The fixed layer pattern 141 may have a magnetization easy axis in a direction perpendicular to a direction that the fixed layer pattern 141 extends. The uni-directional arrow in the fixed layer pattern 141 may indicate that the magnetization direction of the fixed layer pattern 141 is fixed vertically.

The free layer pattern 143 may have a changeable magnetization direction. For example, the magnetization direction of the free layer pattern 143 may be changed according to the program current passing through the free layer pattern 143. According to some embodiments of the present disclosure, the magnetization direction of the free layer pattern 143 may be changed by the spin transfer torque (STT).

The free layer pattern 143 may include at least one magnetic element, for example, at least one among iron (Fe), nickel (Ni), and cobalt (Co), but the embodiments of the present disclosure are not limited thereto.

According to some embodiments of the present disclosure, the free layer pattern 143 may have perpendicular magnetic anisotropy (PMA). The free layer pattern 143 may have a magnetization easy axis in a direction perpendicular to a direction that the free layer pattern 143 extends. The bi-directional arrow in the free layer pattern 143 may indicate that the magnetization direction of the free layer pattern 143 may be magnetized parallel to or antiparallel to the magnetization direction of the fixed layer pattern 141.

According to some embodiments of the present disclosure, the free layer pattern 143 may include a magnetic element that may induce interfacial perpendicular magnetic anisotropy (i-PMA) by being bonded with oxygen. The magnetic element may be, for example, iron (Fe). For example, as described below the free layer pattern 143 may include CoFe or CoFeB.

According to some embodiments of the present disclosure, the free layer pattern 143 may have a crystal structure. For example, at least a portion of the free layer pattern 143 may have a body-centered cubic (BCC) crystal structure.

The tunnel barrier layer pattern 142 may be interposed between the fixed layer pattern 141 and the free layer pattern 143. The tunnel barrier layer pattern 142 may function as a tunnel barrier that enables quantum mechanical tunneling between the fixed layer pattern 141 and the free layer pattern 143.

The tunnel barrier layer pattern 142 may include, for example, at least one among magnesium oxide (MgO), aluminum oxide (Al₂O₃), silicon oxide (SiO₂), tantalum oxide (Ta₂O₅), silicon nitride (SiN), aluminum nitride (AIN), and combinations thereof, but the embodiments of the present disclosure are not limited thereto. For example, it is described below that the tunnel barrier layer pattern 142 includes magnesium oxide having a face-centered cubic (FCC) crystal structure, or a sodium chloride (NaCl) crystal structure.

The MTJ pattern 140 including the fixed layer pattern 141, the tunnel barrier layer pattern 142, and the free layer pattern 143 may function as a variable resistance element that may switch between two resistance states according to an electrical signal applied thereto, for example, a program current. For example, when the magnetization direction of the fixed layer pattern 141 and the magnetization direction of the free layer pattern 143 are parallel to each other, the MTJ pattern 140 may have a low resistance value and store it as data '0'. Conversely, when the magnetization direction of the fixed layer pattern 141 and the magnetization direction of the free layer pattern 143 are antiparallel, the MTJ pattern 140 may have a high resistance value and store it as data '1'.

According to an embodiment of the present disclosure, the fixed layer pattern 141, the tunnel barrier layer pattern 142, and the free layer pattern 143 may be sequentially stacked over the substrate 100, but the embodiments of the present disclosure are not limited thereto, and the stacking order of the fixed layer pattern 141 and the free layer pattern 143 may be changed.

The gap-fill oxide layer 125, the first inter-layer dielectric layer 145, and the second inter-layer dielectric layer 185 are omitted in the plan view of FIG. 1 for clarity of the figure, and these layers may be formed according to the stacking process order of the semiconductor device. These layers are illustrated and described in FIG. 2, which shows a cross-sectional structure.

The gap-fill oxide layer 125 may be formed to fill the space between the first conductive lines 120, provide electrical insulation between the neighboring conductive lines, and serve as a lower support layer for the first electrode layer line 130 that is stacked over the gap-fill oxide layer 125. According to an embodiment of the present disclosure, the gap-fill oxide layer 125 may be formed of silicon oxide (SiO₂) or silicon oxynitride (SiON), and may provide high dielectric stability and excellent planarization property. This oxide layer may be generally planarized through a Chemical Mechanical Polishing (CMP) process or an etch-back process after the oxide layer is deposited in order to uniformly form the upper carbon-based electrode layer.

The first inter-layer dielectric layer 145 may be an insulating base layer that is formed in the space between the MTJ patterns 140 for preventing electrical interference between the neighboring MTJ patterns and for stacking more stably the selector pattern 160 and the carbon-based thin layer pattern 165 subsequently. The first inter-layer dielectric layer 145 may include, for example, silicon nitride (Si₃N₄), and may be formed through a high-density plasma chemical vapor deposition (HDPCVD) process or a low-temperature deposition process. Also, the lower end of the first inter-layer dielectric layer 145 may be formed to contact the first electrode layer line 130 in a region extending in the first direction and to contact the gap-fill oxide layer 125 in the second direction to provide a structural alignment corresponding to the vertical arrangement of the MTJ pattern.

The second inter-layer dielectric layer 185 may be formed in the space between the selector patterns 160 to secure insulation with the second conductive line 120, which is formed subsequently. The second inter-layer dielectric layer may also be formed of silicon nitride (Si₃N₄) or a dielectric material having a similar dielectric property and prevent leakage current when the upper metal line is formed. Also, the lower portion of the second inter-layer dielectric layer 185 may be formed at a position higher than the upper end of the MTJ pattern 140, thereby contributing to protecting the upper portion of the MTJ and maintaining a planar stacked structure of the upper portion. Subsequently, the consistency of the subsequent processes, such as a process of forming a protrusion of the second electrode layer pattern, may be secured through an etch-back process.

FIGS. 3A to 3N are cross-sectional views illustrating a semiconductor device and a method for fabricating the same in accordance with an embodiment of the present disclosure. For the sake of convenience in description, the constituent elements that also appear in FIGS. 1 and 2 are only briefly described or omitted. FIG. 1 is a perspective view illustrating a structure of the semiconductor device in accordance with the embodiment of the present disclosure, and the line A-A' shown in FIG. 1 may represent a cross-section taken by cutting a region extending in the second direction, and the line B-B' may represent a cross-section taken by cutting a region extending in the first direction. In each of FIGS. 3A to 3N, the cross-section according to the line A-A' is presented on the left, and the cross-section according to the line B-B' is presented on the right.

First, the method for fabricating a semiconductor device will be described.

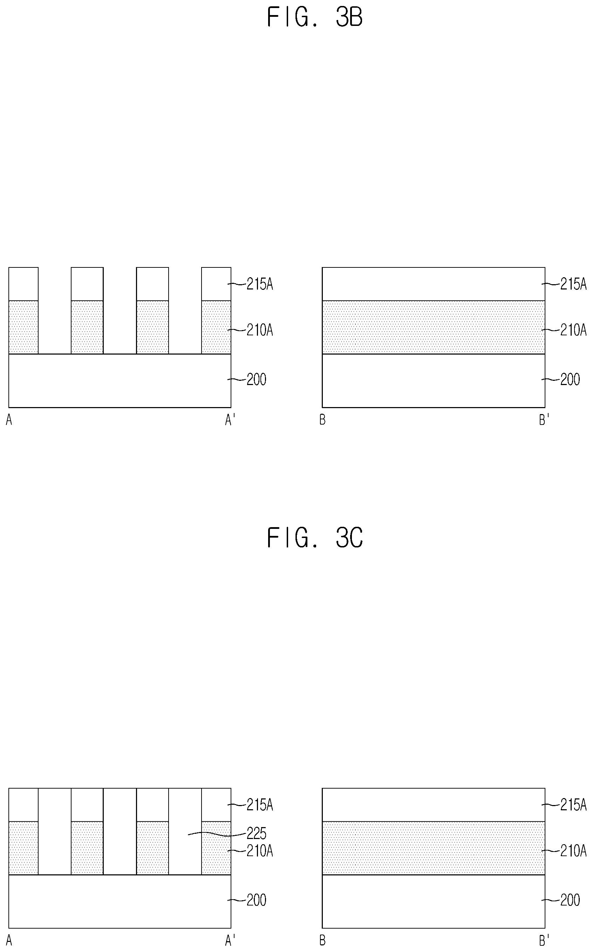

Referring to FIGS. 3A and 3B, a gap-fill layer (not shown) including a trench for forming a first conductive line 210A and a hard mask line 215A may be formed over a substrate 200 where a predetermined lower structure is formed. Subsequently, a first conductive layer 210, and a hard mask layer 215 for forming a hard mask line over the first conductive layer 210 may be sequentially formed in the trench.

The hard mask layer 215 may be formed of, for example, titanium nitride (TiN), tantalum nitride (TaN), tungsten (W), or a combination thereof, and the hard mask layer 215 may function as an etching barrier that stops the etching of the first conductive layer 210 in a subsequent etching process.

Subsequently, by using a line-shaped mask pattern (not shown) extending in the first direction and selectively etching the hard mask layer 215 and the first conductive layer 210, the first conductive line 210A extending in the first direction and the hard mask line 215A formed in the upper portion of the first conductive line 210A may be formed. The etching process may be controlled in such a manner that the hard mask layer is not removed during the etching process but remains in the upper portion, and as a result, the hard mask line 215A may function as an etch stop layer or an upper stacked protective layer in a subsequent process.

The cross-section taken along the line A-A' of FIG. 3B illustrates the first conductive line 210A and the hard mask line 215A in the form of a plurality of patterns that are spaced apart from each other at a regular interval, and the cross-section taken along the line B-B' illustrates layers that are continuous in a horizontal direction. This shows that the first conductive line 210A and the hard mask line 215A over the first conductive line 210A have a line-shaped structure extending in the first direction.

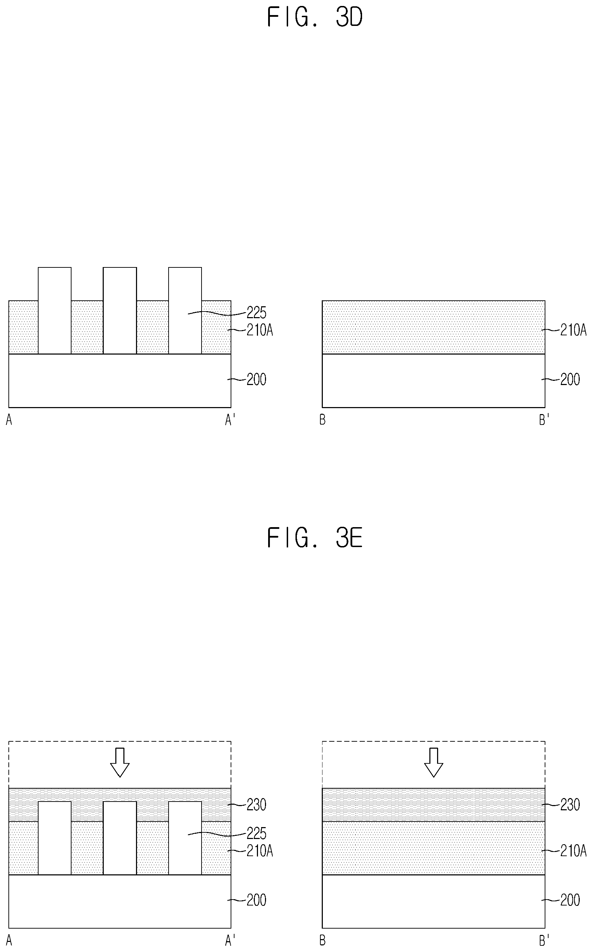

Referring to FIGS. 3C and 3D, a gap-fill oxide layer 225 may be formed to fill the spaces between the first conductive lines 210A and the hard mask lines 215A. The gap-fill oxide layer 225 may be a dielectric layer for minimizing the capacitive or conductive interference between the neighboring conductive lines and improving the insulation property between the interconnections. For example, the gap-fill oxide layer 225 may include an oxide layer material, such as silicon oxide (SiO₂), silicon oxynitride (SiON) and the like.

The gap-fill oxide layer 225 may be deposited by a Chemical Vapor Deposition (CVD) process, and then the upper surface of the gap-fill oxide layer 225 may be planarized through a Chemical Mechanical Polishing (CMP) process. This planarization process may provide a base for uniform deposition and patterning of a first electrode layer line 230, which is to be formed later, and may contribute to improving the upper overlay alignment precision.

After the CMP process, the remaining hard mask line 215A may be removed, for example, through a stripping process to expose the upper surface of the first conductive line 210A. The stripping process may use, for example, a selective wet etching process or a plasma-based dry etching process, and the optimized process conditions may be applied according to the material of the hard mask line 215A, such as titanium nitride (TiN), tantalum nitride (TaN) and the like.

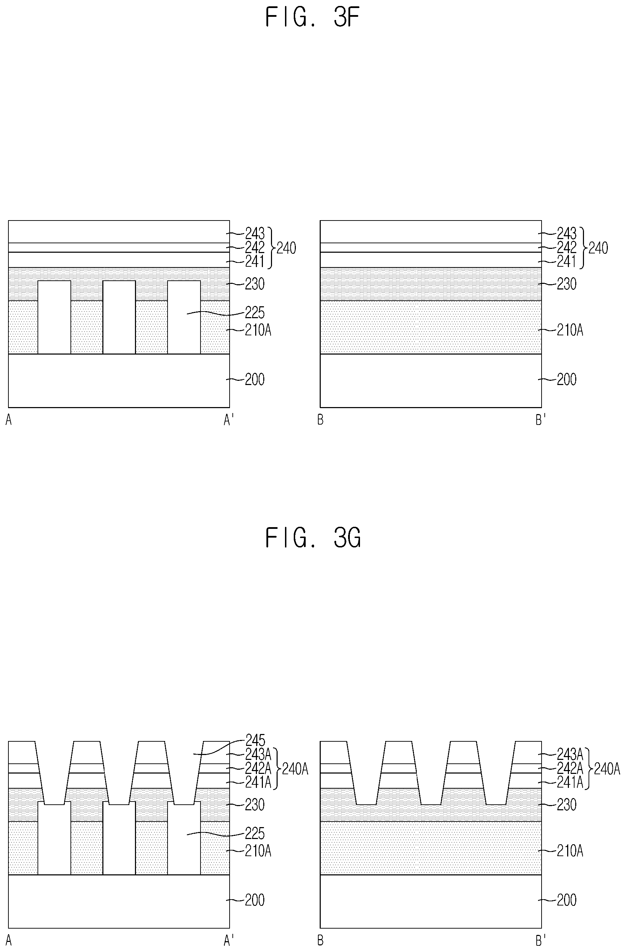

Referring to FIG. 3E, a carbon-based material layer may be deposited on the profile of the process structure of FIG. 3D. The carbon-based material layer may include, for example, a carbon-based material such as amorphous carbon, graphitic carbon, or a doped carbon thin layer, and it may function as a lower electrode layer for forming an MTJ pattern (240A in FIG. 3G) in a subsequent process.

The carbon-based material layer may be etched back and planarized through an Ion Beam Etching (IBE) process. Here, some of the gap-fill oxide layer 225 may be exposed based on the cross-section taken along the line A-A', but it is preferred that the upper surface of the carbon layer may be uniformly maintained for precise alignment of the MTJ.

The carbon-based material layer may also function as a buffer layer or an etch blocking layer for preventing the first conductive line 210A, e.g., a metal conductive layer such as tungsten (W), disposed in the lower portion from being exposed or damaged during the subsequent process of etching the MTJ layer (240 of FIG. 3F). This structure may be effective in suppressing degradation of the reliability resulting from the metal re-deposition or damage during the process of etching the MTJ layer (240 of FIG. 3F).

As a result, the planarized carbon-based material layer may be patterned into a first electrode layer line 230 extending in the first direction and electrically contact the first conductive line 210A. This structure may provide a favorable base for securing uniform stacking and characteristics of the MTJ pattern (240A of FIG. 3G) subsequently.

Referring to FIG. 3F, the MTJ layer 240 may be formed over the planarized first electrode layer line 230. The MTJ layer 240 may include, for example, a stacked structure of a fixed layer 241, a tunnel barrier layer 242, and a free layer 243, which may provide a tunnel magnetization resistance (TMR). The resistance value may vary according to the relative alignment of the magnetization direction.

Since the MTJ layer 240 is formed in a state that the upper surface of the first electrode layer line 230, which is the lower carbon-based electrode layer, is sufficiently planarized, it is possible to prevent deterioration of the MTJ characteristics that may occur due to crystal defects, nonuniform layer thickness, roughness at the interface and the like that may occur during the alignment of a thin layer. In particular, in an MRAM device where the magnetization alignment between the fixed layer 241 and the free layer 243 and the uniformity of the thickness of the tunnel barrier layer 242 are important, the flatness of the lower electrode may have a great influence on the crystal growth and magnetic characteristics.

Therefore, the process of planarizing the first electrode layer line 230 and then forming the MTJ layer 240 over the first electrode layer line 230 may secure stability which is essential for the subsequent processes of MTJ patterning and a data storage operation, which may greatly contribute to improving the fabrication yield and operation reliability of a highly integrated MRAM cell.

Referring to FIG. 3G, by patterning each of the fixed layer 241, the tunnel barrier layer 242, and the free layer 243 through an ion beam etching (IBE) process performed onto the MTJ layer 240, an MTJ pattern 240A including a fixed layer pattern 241A, a tunnel barrier layer pattern 242A, and a free layer pattern 243A may be formed.

When the MTJ pattern is formed in accordance with the embodiment of the present disclosure, the etch stop criterion may be controlled differently for each direction. From the perspective of the cross-section according to the line B-B', the etching process may be controlled to stop based on the upper surface of the carbon-based first electrode layer line 230, and from the perspective of the cross-section according to the line A-A', the etching process may be controlled to stop based on the upper surface of the gap-fill oxide layer 225.

In particular, by controlling the etching process to be performed up to the upper surface of the gap-fill oxide layer 225 based on the cross-section according to the line A-A', the removal of metallic impurities that may be adsorbed on the surface of the corresponding oxide layer during the subsequent process may be facilitated. To be specific, although not illustrated in the figure, it is possible to effectively remove the metallic impurities that may remain on the surface of the oxide layer that is exposed by the etching process by performing the subsequent processes of forming a semi-sidewall (SSW) structure and performing a cleaning (CLN) process. This may play an important role in preventing cross-contamination between the MTJ structures and preventing deterioration of the device reliability.

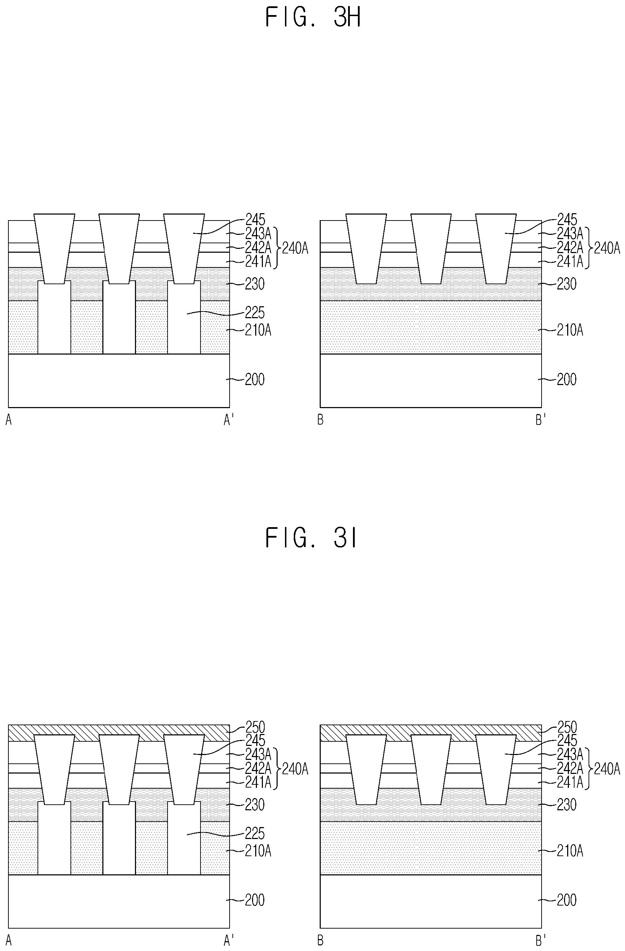

Referring to FIG. 3H, after the formation of the MTJ pattern 240A, the first inter-layer dielectric layer 245 may be formed in the spaces between the MTJ patterns 240A to gap-fill the space between the MTJ patterns 240A, and then a planarization process may be performed.

Although not illustrated in the preceding figures, a semi-sidewall structure forming process and a cleaning process may be performed to remove the metal impurities or etching byproducts that may remain on the sidewall and upper portion of the MTJ pattern 240A and to temporarily protect the MTJ pattern 240A. This process may function as an important protective step, especially for preventing damage to the tunnel barrier layer 242A and the free layer 243A and blocking metal contamination.

Subsequently, the first inter-layer dielectric layer 245 may be formed to gap-fill the space between the MTJ patterns 240A by using a dielectric material such as silicon nitride (Si₃N₄), and the upper surface may be planarized through an etch-back process. The dielectric layer may prevent the electrical interference between the neighboring MTJ patterns 240A and function as an alignment base layer for the upper structure, which is formed subsequently.

Furthermore, there may be a hard mask pattern formed and remaining in the preceding process in the upper portion of the MTJ pattern 240A, which may cause a local step height when the dielectric layer is planarized. However, this step height may be sufficiently compensated through the subsequent processes of depositing the second electrode layer 250 and performing a chemical mechanical polishing (CMP) process, and may not affect securing the top surface flatness of the entire device.

The lower portion of the first inter-layer dielectric layer 245 may contact the first electrode layer line 230 in the area extending in the first direction (the cross-section according to the line B-B') and also contact the gap-fill oxide layer 225 in the area extending in the second direction (the cross-section according to the line A-A'), thereby forming a structure that simultaneously achieves vertical disposition and insulating alignment of the MTJ pattern 240A in this process.

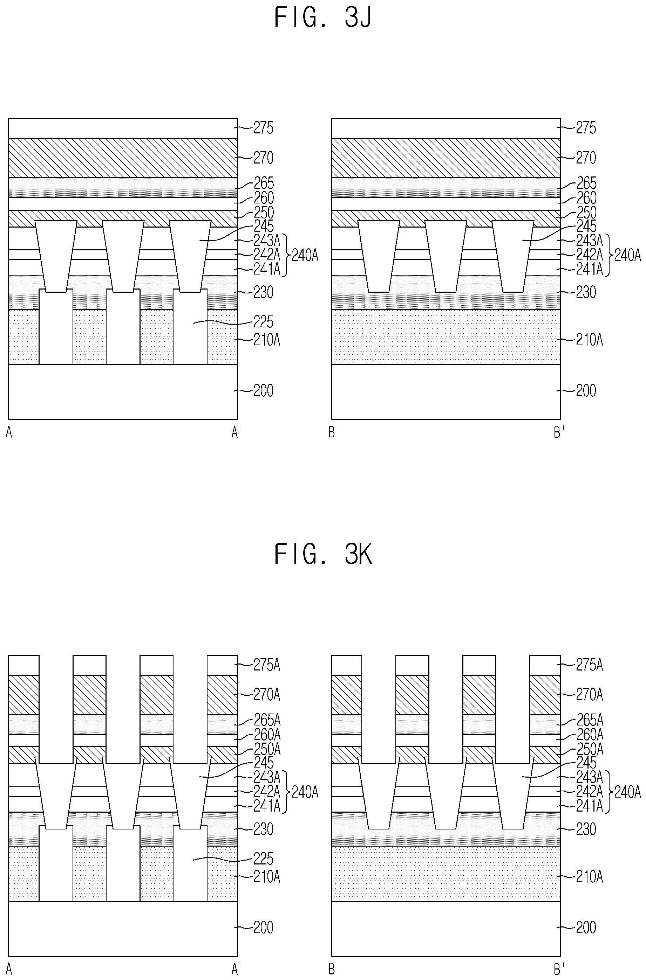

Referring to FIG. 3I, after the planarization of the first inter-layer dielectric layer 245 is completed, a material including a metal or a metal nitride, for example, titanium nitride (TiN), may be deposited on the profile as a base layer for forming a selector pattern (260A of FIG. 3K). The metal nitride layer may function as a lower structure for forming the selector pattern (260A of FIG. 3K) through the subsequent etching process and it may correspond to the second electrode layer 250 that functions as an intermediate electrode layer in this embodiment of the present disclosure.

The upper surface of the deposited titanium nitride (TiN) layer may be planarized through a chemical mechanical polishing (CMP) process, thereby completing an alignment base layer and a shape control reference plane for forming an upper selector pattern (260A of FIG. 3K). The planarization process may be advantageous for increasing the upper patterning precision and preventing misalignment that may be caused due to the step height between the layers in a high-integration cell structure.

Referring to FIG. 3J, a stacked structure for forming a selector unit SU may be sequentially formed over the second electrode layer 250. To be specific, a selector layer 260, a carbon-based thin layer 265, a third electrode layer 270, and a hard mask layer 275 may be stacked over the second electrode layer 250 in the mentioned order.

The selector layer 260 may be formed of, for example, a metal oxide, a metal nitride, or a resistive semiconductor material, and may become a base for forming the selector pattern (260A of FIG. 3K) through a subsequent patterning process. The carbon-based thin layer 265 may be formed of a resistive or conductive carbon material, and then may be coupled to a carbon-based thin layer pattern 265A through a patterning process subsequently. The third electrode layer 270 may be formed of, for example, titanium (Ti), titanium nitride (TiN) and the like.

Subsequently, a nitride-based hard mask layer 275 may be deposited over the top layer. The hard mask layer 275 may be formed of, for example, silicon nitride (Si₃N₄), titanium nitride (TiN), or a composite nitride layer, and may function as an etch stop layer during the subsequent selector patterning process and may perform the functions of step height compensation and physical protection during an upper layer alignment process.

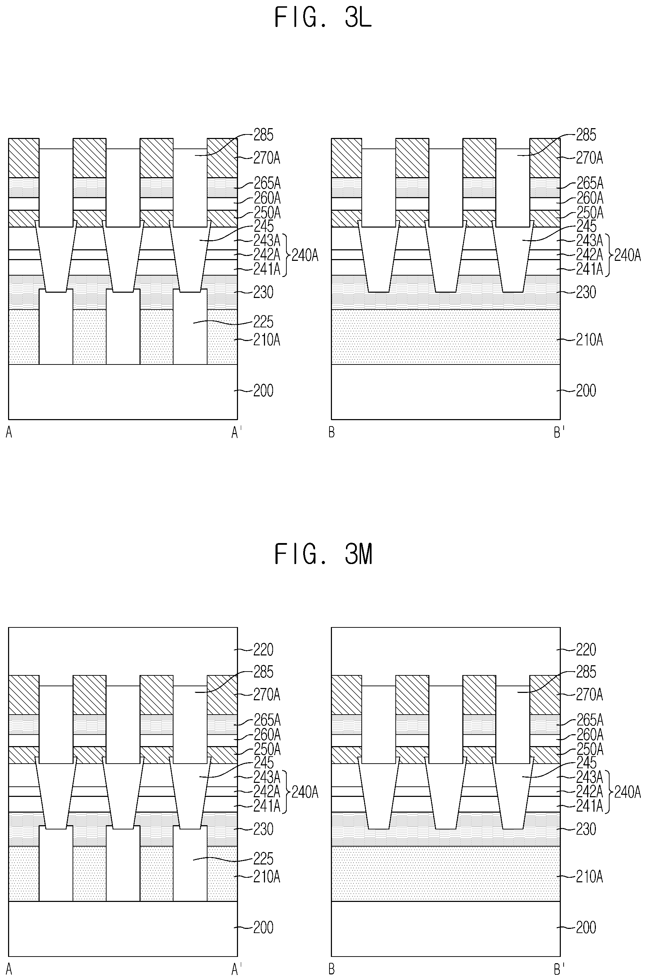

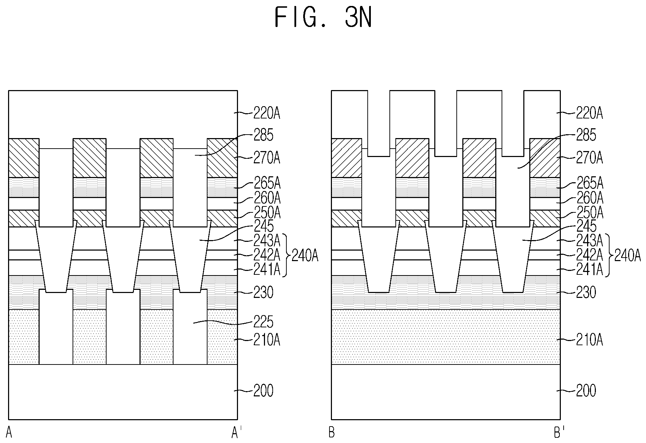

In particular, after the selector and electrode patterning processes, it may be advantageous to control the etching conditions in such a manner that only the selected hard mask (NIT) among the hard mask layers may remain. This may simplify the process of removing unnecessary additional metal hard mask, and then may also contribute to securing flatness when the second inter-layer dielectric layer (285 in FIG. 3L) and the second conductive line (220A in FIG. 3N) are formed. At this stage, the hard mask layer 275 may serve as a selective barrier, distinguishing between regions intended to remain and those designated for removal according to the process design.

Referring to FIG. 3K, by patterning the second electrode layer 250, the selector layer 260, the carbon-based thin layer 265, the third electrode layer 270, and the hard mask layer 275 through lithography and etching processes, the second electrode layer pattern 250A, the selector pattern 260A, the carbon-based thin layer pattern 265A, the third electrode layer pattern 270A, and the hard mask pattern 275A may be formed, respectively.

The etching process may be performed by a Reactive Ion Etching (RIE) process. Damage to the MTJ pattern 240A may be prevented by using the first inter-layer dielectric layer 245 disposed in the lower portion as an etch stop layer. This may enable independent pattern isolation of the selector unit SU and minimize deterioration of the characteristics of the MTJ pattern 240A and electrical interference of the MTJ pattern 240A.

The second electrode layer pattern 250A may be a metal or metal nitride-based electrode that is formed over the first inter-layer dielectric layer 245, and may serve as an intermediate electrode layer that electrically connects the lower MTJ pattern 240A and the selector unit SU.

The selector pattern 260A may be a structure that functions as a current selection element, gives non-linear current characteristics according to the material, and enables a selective operation of the MTJ cell. It may be a key switching layer that controls the current together with the upper and lower electrodes.

The carbon-based thin layer pattern 265A may be a carbon-based control layer having conductive or resistive characteristics in the selector unit SU, and an amorphous carbon layer, a graphite carbon layer, a doped carbon layer and the like may be used, and the carbon-based thin layer pattern 265A may adjust the characteristics of the selector pattern 260A and increase the process compatibility.

The third electrode layer pattern 270A may be an electrode of the upper portion of the selector pattern 260A, and the third electrode layer pattern 270A may be electrically connected to the upper interconnection, for example, the second conductive line (220A in FIG. 3N), and may function as an electric signal transfer layer for controlling a selection operation of the selector pattern 260A.

The hard mask pattern 275A may function as an etch stop layer and a protective layer during the subsequent process of forming an inter-layer dielectric layer and the subsequent process of forming the metal interconnection, and the hard mask pattern 275A may also be used as a pattern alignment reference plane during the process of forming the upper structure. It may contribute to securing the consistency of the subsequent process and flatness by controlling it to remain selectively.

Referring to FIG. 3L, a second inter-layer dielectric layer 285 may gap-fill the space between the second electrode layer pattern 250A, the selector pattern 260A, the carbon-based thin layer pattern 265A, and the third electrode layer pattern 270A. The second inter-layer dielectric layer 285 may be formed of a dielectric material such as silicon nitride (Si₃N₄) and the like, for blocking the electrical interference between the neighboring selector units and serving as a dielectric layer when an upper metal interconnection is formed.

The formed second inter-layer dielectric layer 285 may gap-fill the space between the selector patterns 260A, and then the upper portion may be planarized through an etch-back process, thereby controlling the profile in such a manner that the third electrode layer pattern 270A is maintained to protrude to the upper surface of the second inter-layer dielectric layer 285. This protrusion structure may secure electrical connection with the upper interconnection, for example, the second conductive line (220A in FIG. 3N), while allowing direct connection without forming an additional contact hole.

Also, the hard mask pattern 275A remaining in the preceding operation may be selectively removed in this operation, which contributes to improving the planarization of the dielectric layer and the shape consistency of the subsequent structure. Also, the hard mask pattern 275A may be removed in this operation, and the removal moment may be designed in consideration of the etching selectivity and the inter-layer alignment.

Referring to FIGS. 3M and 3N, the second conductive line 220A may be formed by depositing a metal interconnection material in the upper portion of the third electrode layer pattern 270A to form a second conductive layer 220, and then patterning the second conductive layer 220 in a line shape extending in the second direction. The second conductive line 220A may serve as a bit line and, function as an upper metal interconnection. It may provide a selective electrical path for signal transmission to the underlying selector unit (SU) and memory unit (MU).

The metal for forming the second conductive line 220A may be, for example, tungsten (W) or another high-conductivity metal, and may be patterned into the second conductive line 220A through a lithography process and an etching process after the metal deposition. The lower MTJ pattern 240A may be affected by a metal re-deposition, plasma damage, or physical damage that may occur during the metal etching process. In particular, since the MTJ pattern 240A has a relatively low height, it is highly susceptible to damage when directly exposed during the etching of the second conductive line 220A.

According to an embodiment of the present disclosure, to prevent damage to the lower element, particularly, the MTJ pattern 240A, during the process of forming the second conductive line 220A, the vertical stacking structure of the element and the insulation design may be precisely formed.

First, the second conductive line 220A may be formed over the third electrode layer pattern 270A, and the third electrode layer may be formed to have a relatively high shape, i.e., a protruding shape so that it may function as a physical buffer layer against the plasma impact or metal re-deposition that may occur during the metal etching process.

Also, the selector pattern 260A disposed in the lower portion may be sufficiently buried by the third electrode layer pattern 270A and the second inter-layer dielectric layer 285 and may have a structure separated from the etching path of the second conductive line 220A. Furthermore, the MTJ pattern 240A may be buried in multiple layers by the first inter-layer dielectric layer 245 and the second inter-layer dielectric layer 285 to be stably protected without direct exposure during the patterning of the second conductive line 220A.

The stacking and insulating structure may make it possible to stably maintain the magnetic and tunneling characteristics of the MTJ pattern 240A after the formation of the second conductive line 220A even in a high-integration device environment.

As a result of the above process, the semiconductor device in accordance with an embodiment of the present disclosure may be formed.

Referring back to FIG. 3N, according to an embodiment of the present disclosure, the semiconductor device may be formed to include first conductive lines 210A, gap-fill oxide layers 225 formed between the first conductive lines 210A, a carbon-based first electrode layer line 230 formed over the first conductive lines 210A and the gap-fill oxide layers 225, an MTJ pattern 240A stacked over the carbon-based first electrode layer line 230, a first inter-layer dielectric layer 245 gap-filling the space between the MTJ patterns 240A, a second electrode layer pattern 250A, a selector pattern 260A, a carbon-based thin layer pattern 265A, and a third electrode layer pattern 270A that are stacked over the MTJ pattern 240A, a second inter-layer dielectric layer 285 gap-filling the space between the stacks of the second electrode layer pattern 250A, the selector pattern 260A, the carbon-based thin layer pattern 265A, and the third electrode layer pattern 270A, and a second conductive line 220A formed over the third electrode layer pattern 270A.

According to this process flow, since the lower memory unit MU and the upper selector unit SU are independently patterned and stacked, a high-integration three-dimensional vertically stacked structure may be realized without damaging the magnetic property and tunnel property of the MTJ pattern 240A.

In particular, because the MTJ pattern 240A is embedded and shielded within multiple layers by the first and second inter-layer dielectric layers 245 and 285, it remains unaffected during the metal etching process of the upper second conductive line 220A. This configuration helps minimize potential damage from etching plasma and metal re-deposition. In short, this layered structure effectively protects the MTJ pattern during fabrication.

Also, the selector unit SU may be formed vertically from the second electrode layer pattern 250A to the third electrode layer pattern 270A, and since the third electrode layer pattern 270A is maintained in a protruding shape after the etch-back process of the upper dielectric layer, it may be easily coupled to the second conductive line 220A and may be directly coupled without a contact hole forming process. Accordingly, the effects of improving process simplification and overlay alignment precision may be secured at the same time.

Furthermore, since the third electrode layer pattern 270A has a sufficient height and functions as an etching buffer during the patterning process of the second conductive line 220A, which is the upper metal line, the selector pattern 260A and the lower MTJ pattern 240A may not be damaged but protected stably. This structure may improve the stability of the electrical characteristics and process reliability, and may also be advantageous for securing the life span of the device and the consistent characteristics.

Also, as the second conductive line 220A is formed directly over the selector pattern 260A and the third electrode layer pattern 270A, the contact area may become wide and the alignment may become excellent so that the signal transfer quality may be improved even during a high-speed operation. Accordingly, it may be highly likely to be applied to high-speed, high-density MRAM devices or other nonvolatile memory devices, and both of the easy process control and mass production stability may be secured at the same time.

According to an embodiment of the present disclosure, the semiconductor device and the method for fabricating the same may prevent damage to the lower portion during an etching process of a Magnetic Tunnel Junction (MTJ) and improve the process precision of the etching process by disposing a Magnetic Tunnel Junction (MTJ) pattern in the lower portion of a cell, using a carbon-based thin layer as an electrode layer and an etch stop layer, and using a silicon nitride (NIT) dielectric layer as an etch stop layer during a selector pattern etching process. Also, since the electrical interference between the cells may be prevented, the reliability and yield of the MTJ pattern may be improved, and the stability of the formation of the upper structure may be enhanced by securing the flatness of the upper portion of the MTJ pattern. Furthermore, since it is possible to protect the MTJ pattern from a subsequent process and perform precise patterning based on a structure in which a metal or metal nitride-based hard mask layer remains in the upper portion of the MTJ pattern, the stability of the entire process and the PMI (Process Management Index) may be improved.

While the present invention has been described with respect to specific embodiments, it will be apparent to those skilled in the art that various changes and modifications may be made without departing from the spirit and scope of the invention as defined in the following claims. Furthermore, the embodiments may be combined to form additional embodiments.

## Claims

1. A semiconductor device comprising:
a first conductive line extending in a first direction;
a gap-fill oxide layer filling a region disposed adjacent to the first conductive line;
a first electrode layer line formed over the first conductive line and including a carbon-based material;
a magnetic tunnel junction (MTJ) pattern formed over the first electrode layer line;
a first inter-layer dielectric layer formed in a space adjacent to the MTJ pattern;
a selector pattern disposed over the MTJ pattern;
a carbon-based thin layer pattern disposed over the selector pattern;
a second inter-layer dielectric layer formed in a space adjacent to the selector pattern; and
a second conductive line disposed over the carbon-based thin layer pattern and extending in a second direction that intersects with the first direction.

2. The semiconductor device of claim 1, wherein the gap-fill oxide layer includes silicon oxide (SiO₂) or silicon oxynitride (SiON).

3. The semiconductor device of claim 1, wherein the first electrode layer line includes one or more selected from a group including an amorphous carbon layer, a graphitic carbon layer, and a doped carbon thin layer.

4. The semiconductor device of claim 1, wherein the first inter-layer dielectric layer and the second inter-layer dielectric layer include silicon nitride.

5. The semiconductor device of claim 1, wherein a lower end of the first inter-layer dielectric layer contacts the first electrode layer line in a region extending in the first direction and contacts the gap-fill oxide layer in a region extending in the second direction.

6. The semiconductor device of claim 1, wherein the first electrode layer line has a planar upper surface and is formed not to expose the gap-fill oxide layer.

7. The semiconductor device of claim 1, further comprising:
a second electrode layer pattern disposed over the carbon-based thin layer pattern,
wherein the second electrode layer pattern includes titanium nitride (TiN), tantalum nitride (TaN), tungsten (W), titanium (Ti), or a combination thereof.

8. The semiconductor device of claim 1, wherein a lower end of the second inter-layer dielectric layer is positioned higher than an upper end of the MTJ pattern.

9. The semiconductor device of claim 1, wherein the carbon-based thin layer pattern includes one or more selected from a group including an amorphous carbon layer, a graphitic carbon layer, and a doped carbon thin layer.

10. A method for fabricating a semiconductor device, the method comprising:
forming a first conductive line extending in a first direction;
forming a gap-fill oxide layer by filling a region between the first conductive lines with an oxide layer;
forming a first electrode layer line including a carbon-based material over the gap-fill oxide layer;
forming a magnetic tunnel junction (MTJ) layer over the first electrode layer line;
forming an MTJ pattern by patterning the MTJ layer with the first electrode layer line or the gap-fill oxide layer used as an etch stop layer;
forming a first inter-layer dielectric layer in a space between the MTJ patterns;
forming a selector layer over the MTJ pattern and forming a carbon-based thin layer over the selector layer;
forming a selector pattern by patterning the selector layer with the first inter-layer dielectric layer used as an etch stop layer; and
forming a second conductive line extending in a second direction that intersects with the first direction over the selector pattern.

11. The method of claim 10, wherein the first inter-layer dielectric layer includes silicon nitride.

12. The method of claim 10, wherein forming the MTJ pattern is performed by an Ion Beam Etching (IBE) process.

13. The method of claim 10, wherein in forming the MTJ pattern,
an etch stop in the first direction is controlled with respect to the first electrode layer line, and
an etch stop in the second direction is controlled with respect to the gap-fill oxide layer.

14. The method of claim 10, wherein forming the first electrode layer line includes:
depositing a carbon-based thin layer over the gap-fill oxide layer; and
performing an etch-back process not to expose the gap-fill oxide layer.

15. The method of claim 10, wherein forming the selector pattern is performed by a Reactive Ion Etching (RIE) process.
